# EUROPEAN PATENT APPLICATION

(11) **EP 1 523 035 A2**
(43) Date of publication of application: **13.04.2005**
(21) Application number: 04256242.1
(22) Date of filing: 08.10.2004
(51) Int. Cl.: H01L 23/29, H01L 23/31

(54) **Semiconductor package**

(30) Priority: 08.10.2003 JP 2003349031
(71) Applicant: SHIN-ETSU CHEMICAL CO., LTD., Chiyoda-ku, Tokyo (JP)
(72) Inventor: Fukuda, Kenichi Shin-Etsu Chemical Co. Ltd., Usui-gun Gunma-ken (JP); Shiono, Mikio Shin-Etsu Chemical Co. Ltd., Usui-gun Gunma-ken (JP)
(74) Representative: Stoner, Gerard Patrick

(57) **Abstract**

A semiconductor package comprises a semiconductor chip, leads, and bonding wires wherein at least portions of the chip, bonding wires and leads are covered and protected with an electrically insulating fluorochemical material which is a cured product of a curable composition comprising (A) a polyfluorodialkenyl compound comprising -(CF(CF₃)-CF₂-O)-units and having alkenyl groups at both ends of its molecular chain, (B) an organohydrogenpolysiloxane having at least two Si-H groups, and (C) a platinum group metal catalyst.

## Description

This invention relates to a semiconductor package which is covered and protected with a fluorochemical material having a low permittivity, good reliability (heat resistance and moisture resistance), and a low modulus.

### BACKGROUND

Resin encapsulation semiconductor packages in which semiconductor devices such as diodes, transistors, ICs and LSIs are resin molded, i.e., encapsulated by transfer molding of encapsulating materials, typically epoxy resin compositions have many advantages including improved reliability (heat resistance and moisture resistance), mass scale productivity and low cost. They are widely used in the art as well as ceramic semiconductor packages.

Recent efforts have been made to enhance the function and performance of semiconductor devices in microprocessors or the like, which invites a tendency of drastically increasing the operating frequency. In information and communication-related fields, especially for small size electronic devices such as mobile phones and PHS, a nearly giga-hertz frequency band is now utilized. Even a challenge for communications in a two digit giga-hertz frequency band is in progress.

While the operating frequency of semiconductor devices becomes higher, ceramic packages having improved high-frequency performance are currently employed for most semiconductor devices requiring high reliability. However, a replacement by resin encapsulation semiconductor packages is under consideration by virtue of their mass scale productivity and reliability in several aspects.

The increased semiconductor frequency accelerated to fabricate circuits at finer pitches. Particularly in high-speed system device applications, the cured resin composition must have a low permittivity in order to reduce the noise between adjacent wirings. A pulse propagation velocity V which is an index of the high-speed system is related to a wiring capacitance C as${\text{V = C/ε}}_{\text{r}} {\text{}}^{\text{1/2}}$ wherein εᵣ is a relative permittivity, which means that a lower permittivity is synonymous with a faster signal speed. In view of ordinary cured resins having a relative permittivity of 4.0 to 4.6, a resin composition having a lower permittivity is desirable for high-speed system device applications.

In this regard, JP-A 10-298407 and JP-A 2001-354754 disclose epoxy resin compositions which are loaded with hollow inorganic fillers for the purpose of reducing permittivity. It was also proposed in JP-A 2001-40182 to incorporate fluoro-resin particles in epoxy resin compositions.

For epoxy and similar resins having a high modulus in the cured state, however, it was observed that bonding wires connecting a semiconductor chip to leads can be broken by thermal stresses, mechanical stresses or the like. It is desired to develop a material having a lower modulus as the encapsulating material that applies minimized stress to bonding wires.

An object of the invention is to provide semiconductor packages which are covered and protected with a fluorochemical material having a low permittivity, good reliability (heat resistance and moisture resistance), and a low modulus, and methods of making such semiconductor packages.

The inventors have found that a curable composition comprising an alkenyl-containing fluoropolymer comprising -(CF(CF₃)-CF₂-O)- units, an organohydrogenpolysiloxane having at least two silicon atom-bonded hydrogen atoms in a molecule, and a platinum group metal catalyst enables cured products having a low permittivity and a low modulus as compared with conventional semiconductor-encapsulating resin compositions, and that the use of this fluorochemical material as an encapsulating material for semiconductor devices can lead to semiconductor packages having improved high-frequency performance, mitigated temperature history, minimized mechanical impact, and high operational reliability.

The present invention provides a semiconductor package comprising a semiconductor chip, leads for conveying electrical signals, and bonding wires for electrically connecting said chip and said leads, at least portions of the chip, the bonding wires and the leads being covered and protected with an electrically insulating fluorochemical material. The fluorochemical material is a cured product of a curable composition comprising
(A) 100 parts by weight of a chain-like polyfluorodialkenyl compound having alkenyl groups at both ends of its molecular chain and comprising a backbone represented by the formula: 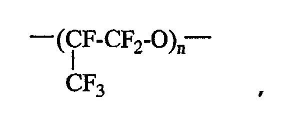
(B) an effective amount of an organohydrogenpolysiloxane having at least two silicon atom-bonded hydrogen atoms in a molecule, and
(C) a catalytic amount of a platinum group metal catalyst.

The semiconductor package of the invention is covered and protected with a fluorochemical material having a low permittivity or dielectric constant, improved reliability (heat resistance and moisture resistance), and a low modulus.

Use of the defined curable compositions for protecting or encapsulating semiconductor packages is a further aspect.

FIGS. 1 to 3 are transverse cross-sectional views of semiconductor packages according to different embodiments of the invention.

FIG. 4 is a graph showing the frequency response of relative permittivity of a fluorochemical material used in the semiconductor package of the invention.

### FURTHER EXPLANATIONS; OPTIONS AND PREFERENCES

In connection with the drawings, the invention is described by referring to an embodiment wherein the semiconductor package is applied to that operating in a high-frequency region, although the invention is not limited thereto.

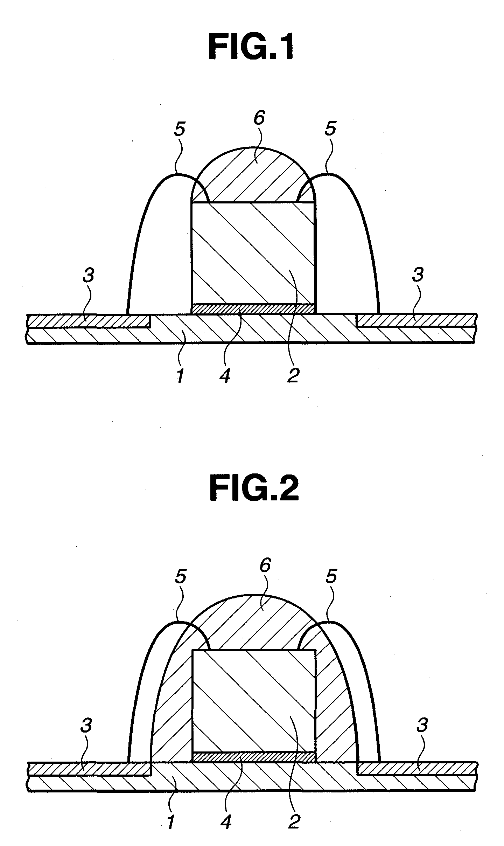

FIGS. 1 to 3 are transverse cross-sectional views of main portions of semiconductor packages according to different embodiments of the invention. A substrate 1 is made of a filled epoxy resin or alumina, for example. A semiconductor chip 2 is mounted on the substrate 1. The substrate 1 is provided with a plurality of insert pins or leads 3 which are made of a conductive material such as silver, gold or copper.

The semiconductor chip 2 is not particularly limited and may be of any well-known construction. The semiconductor chip 2 is bonded to the substrate 1, for example, with an epoxy base adhesive 4 and electrically connected to the insert pins or leads 3 via bonding wires 5 of gold, aluminum or the like.

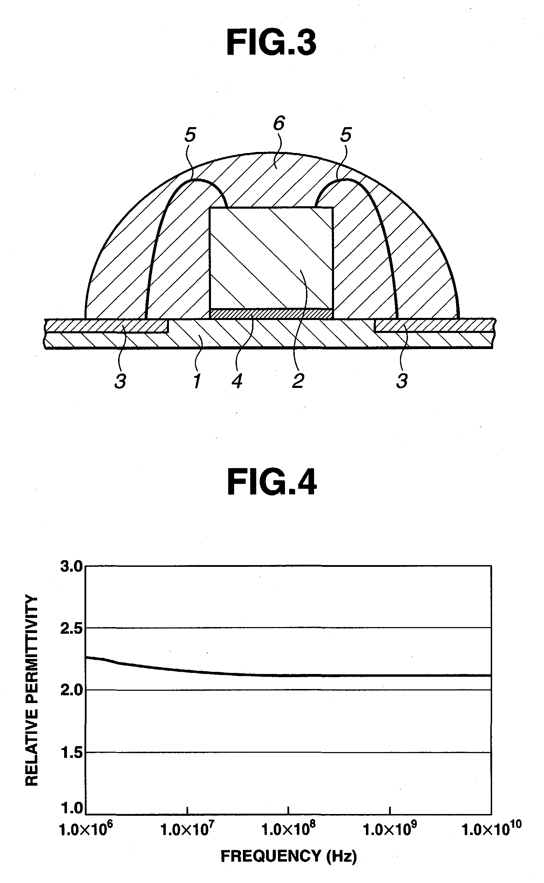

As a protective material 6 for providing protection, electrical insulation, anti-corrosion and other functions to the semiconductor chip 2 and bonding wires 5, a fluorochemical material is applied so as to cover the semiconductor chip 2, bonding wires 5 and the like. In FIG. 1, the protective material 6 covers and protects a portion of the semiconductor chip 2 and the connections between the semiconductor chip 2 and bonding wires 5. In FIG. 2, the protective material 6 covers and protects the entire semiconductor chip 2 and the connections between the semiconductor chip 2 and bonding wires 5. In FIG. 3, the protective material 6 covers and protects the entire semiconductor chip 2, the entire bonding wires 5, the connections between the semiconductor chip 2 and bonding wires 5, and the connections between the insert pins 3 and bonding wires 5.

Better results are obtained when the protective material is a product obtainable by curing a composition comprising
(A) 100 parts by weight of a chain-like polyfluorodialkenyl compound having alkenyl groups at both ends of its molecular chain and comprising a backbone represented by the formula: 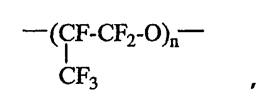
(B) an effective amount of an organohydrogenpolysiloxane having at least two silicon atom-bonded hydrogen atoms in a molecule, and
(C) a catalytic amount of a platinum group metal catalyst.

In addition to components (A) to (C), the curable composition may further comprise (D) 40 to 160 parts by weight of a chain-like polyfluoromonoalkenyl compound having an alkenyl group at one end of its molecular chain and comprising a backbone represented by the formula: 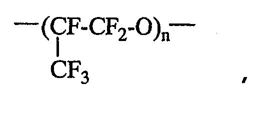 and/or (E) 0.1 to 3.0 parts by weight of an organosilicon compound having at least one of trialkoxysilyl and epoxy groups in a molecule.

A portion to be protected can be covered with the curable composition by molding or potting the composition and heat curing, for example, at 120 to 150°C for about one hour.

The thus cured composition has low permittivity characteristics in a high-frequency region as shown in FIG. 4. The cured composition has a relative permittivity of up to 2.5, especially up to 2.4, at 23°C in a frequency region of at least 1 MHz, enabling the manufacture of semiconductor packages that fully accommodate the higher operating frequency of semiconductor devices.

It is noted that measurement of relative permittivity is done in accordance with JIS K6249.

Now suitable fluorochemical materials and curable compositions are described in detail.

### Component A

Component (A) used in the curable composition is an alkenyl-containing fluoropolymer comprising -(CF(CF₃)-CF₂-O)-units. This branched polyfluorodialkenyl compound is preferably one represented by the general formula (1).

CH₂=CH-(X)ₐ-Rf¹-(X')ₐ-CH=CH₂ (1)

Herein X is a divalent group selected from among -CH₂-, -CH₂O-, -CH₂OCH₂- and -Y-NR¹-CO-, wherein Y is -CH₂- or a divalent group of the formula: 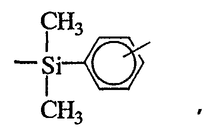 and R¹ is hydrogen or a substituted or unsubstituted monovalent hydrocarbon group.

X' is a divalent group selected from among -CH₂-, -OCH₂-, -CH₂OCH₂- and -CO-NR¹-Y'-, wherein Y' is -CH₂- or a divalent group of the formula: 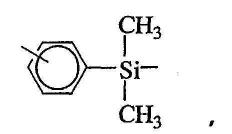 and R¹ is as defined above.

The subscript "a" is independently 0 or 1.

Rf¹ is a divalent group of the general formula (i) or (ii).

-CₜF₂ₜ- [OCF₂CF(CF₃)]ₚ-[OCF₂(CF₂)ᵣCF₂O]-[CF(CF₃)CF₂O]_{q}-CₜF₂ₜ- (i)

Herein p and q each are an integer of at least 1, the sum of p+q is 2 to 200 on average, r is an integer of 0 to 6, and t is 2 or 3.

-CₜF₂ₜ-[OCF(CF₃)CF₂]ᵤ-(OCF₂)ᵥ-OCₜF₂ₜ- (ii)

Herein u is an integer of 1 to 200, v is an integer of 1 to 50, and t is as defined above.

R¹ included in X or X' is hydrogen or a substituted or unsubstituted monovalent hydrocarbon group, preferably of 1 to 12 carbon atoms, more preferably 1 to 10 carbon atoms. Examples include alkyl groups such as methyl, ethyl, propyl, butyl, hexyl, cyclohexyl and octyl, aryl groups such as phenyl and tolyl, aralkyl groups such as benzyl and phenylethyl, and substituted forms of the foregoing monovalent hydrocarbon groups in which some or all of the hydrogen atoms are substituted with halogen atoms such as fluorine.

Rf¹ is a divalent group of formula (i) or (ii).

-CₜF₂ₜ-[OCF₂CF(CF₃)]ₚ-[OCF₂(CF₂)ᵣCF₂O]-[CF(CF₃)CF₂O]_{q}-CₜF₂ₜ- (i)

Herein p, q, r, and t are as defined above.

-CₜF₂ₜ-[OCF(CF₃)CF₂]ᵤ-(OCF₂)ᵥ-OCₜF₂ₜ- (ii)

Herein u, v, and t are as defined above.

Illustrative examples of formula (i) are those of formula (i').

-CF₂CF₂-[OCF₂CF(CF₃)]ₛ-OCF₂(CF₂)ᵣCF₂O-[CF(CF₃)CF₂O]ₜ-CF₂CF₂- (i')

Herein s and t each are an integer of at least 1, the sum of s+t is 2 to 200 on average.

Three typical examples of Rf¹ are given below. Of these, divalent groups of the first structural formula are preferred. 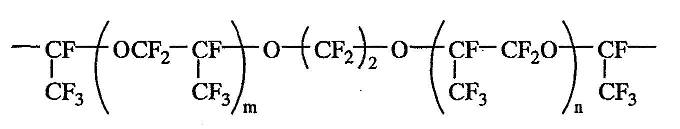 Herein m and n each are an integer of at least 1, and m+n (average) = 2 to 200. 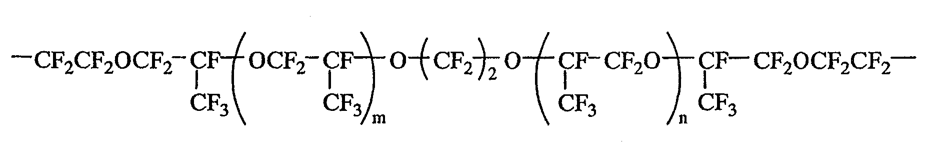 Herein m and n each are an integer of at least 1, and m+n (average) = 2 to 200. 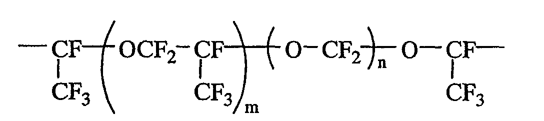 Herein m is an integer of 1 to 200, and n is an integer of 1 to 50.

Illustrative, non-limiting examples of the polyfluorodialkenyl compound having formula (1) are given below. 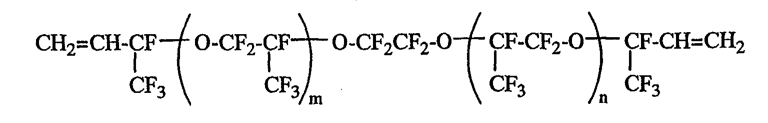 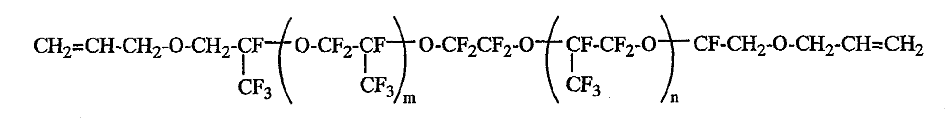 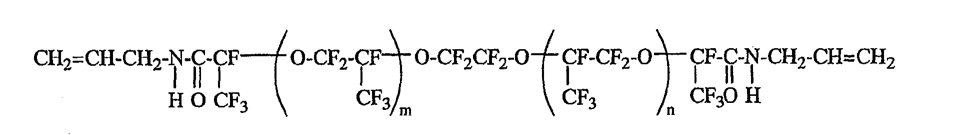 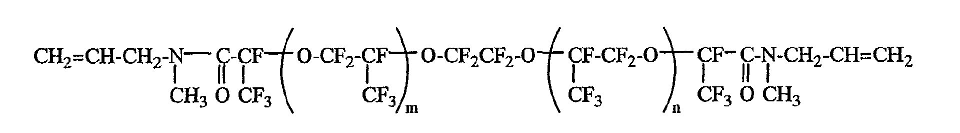 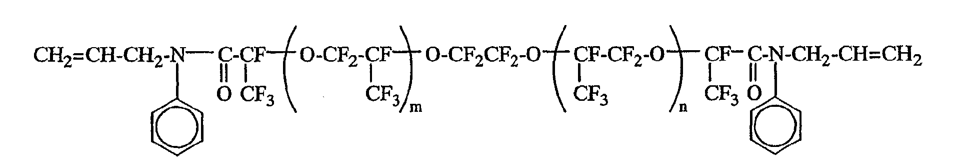 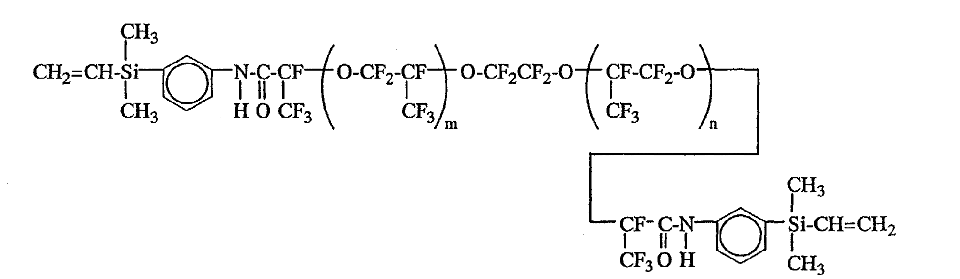 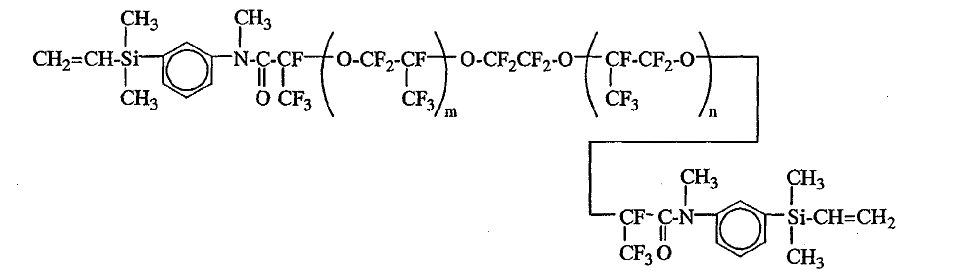 Herein m and n each are an integer of at least 1, and m+n (average) = 2 to 200.

The polyfluorodialkenyl compound having formula (1) should preferably have a viscosity at 23°C in the range of 5 to 100,000 mPa·s because the resulting composition has an appropriate flow on use and its cured product has appropriate physical properties. Within this viscosity range, an optimum viscosity may be selected depending on a particular application.

### Component B

Component (B) is an organohydrogenpolysiloxane having at least two hydrogen atoms each attached to a silicon atom in a molecule. The organohydrogenpolysiloxane (B) should have at least two hydrosilyl groups (i.e., Si-H groups) in a molecule in view of its function as a crosslinker and chain extender for component (A), and should preferably have at least one fluorinated group in view of its compatibility and dispersion with component (A) and cured uniformity.

Suitable fluorinated groups include those of the following general formulae.

C_{s'}F_{2s'+1}-

Herein s' is an integer of 1 to 20, preferably 2 to 10.

F-[CF(CF₃)CF₂O]ₙ-CₜF₂ₜ-

Herein n is an integer of 2 to 200, preferably 2 to 100, and t is an integer of 1 to 3.

-C_{t'}F_{2t'}-

Herein t' is an integer of 1 to 20, preferably 2 to 10.

-CF(CF₃)-[OCF₂CF(CF₃)]ₘ-O-CF₂CF₂-O-[CF(CF₃)CF₂O]ₙ-CF(CF₃)-

Herein m and n each are an integer of at least 1, m+n (average) = 2 to 200, preferably 2 to 100.

Examples of suitable organohydrogenpolysiloxane having such a fluorinated group are given below. These compounds may be used alone or in admixture of any. In the formulae below, Ph is phenyl.

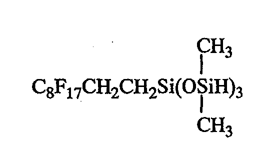

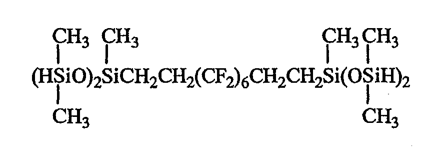

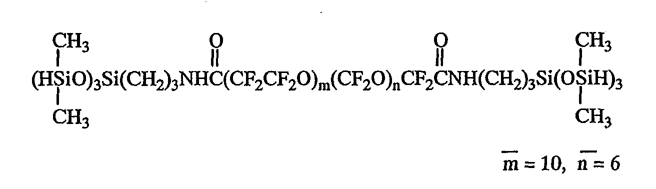

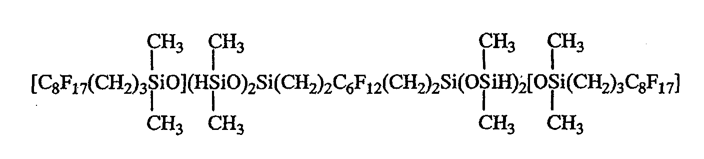

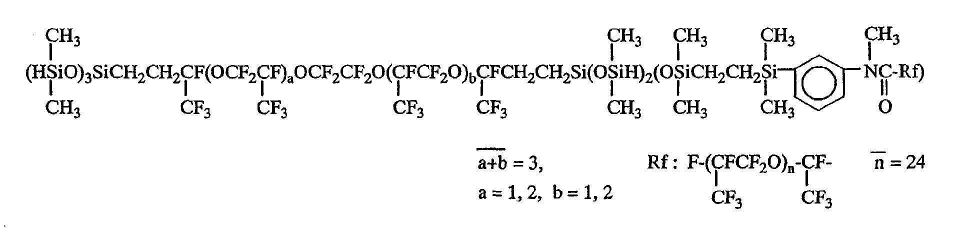

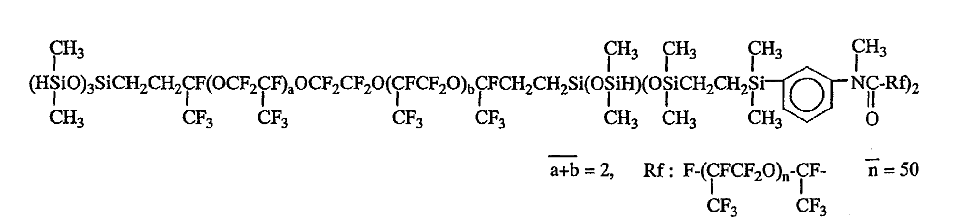

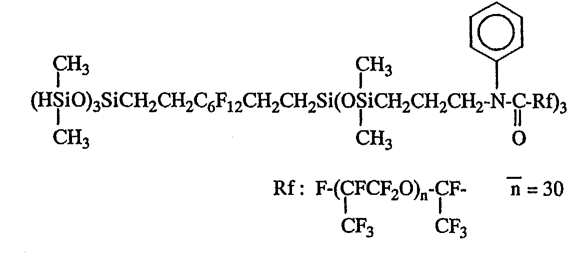

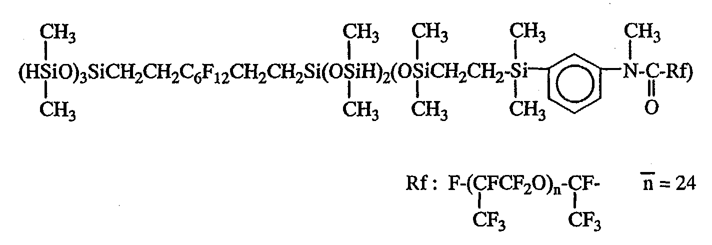

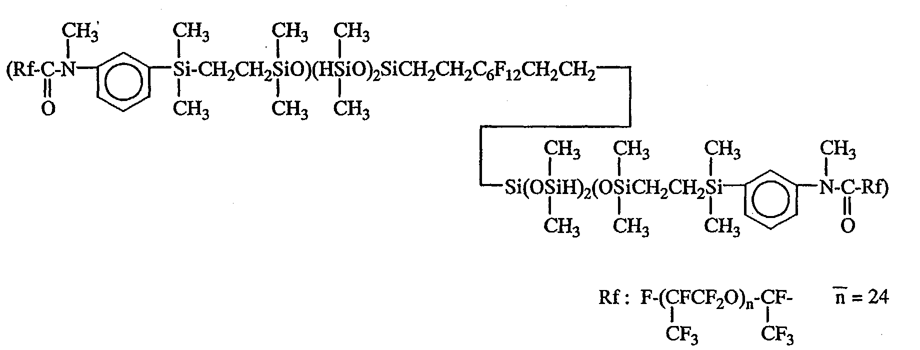

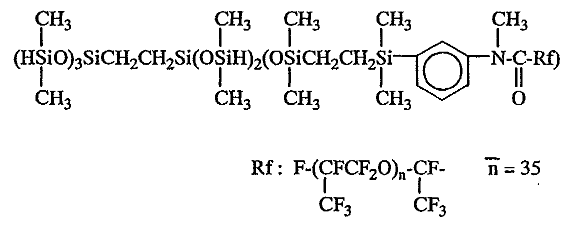

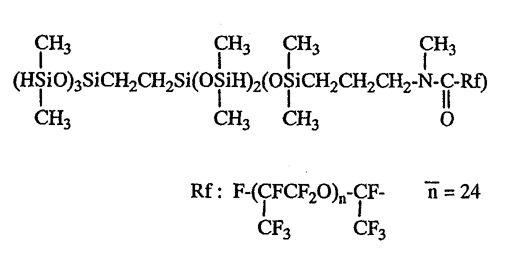

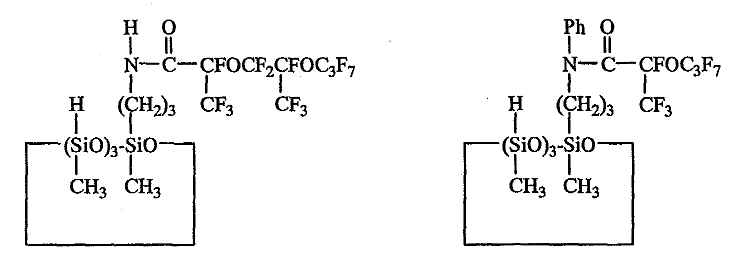

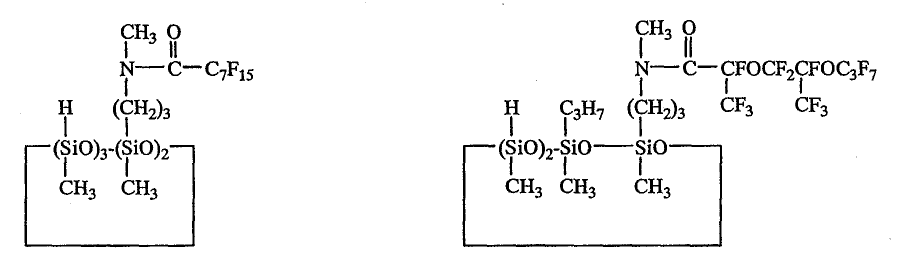

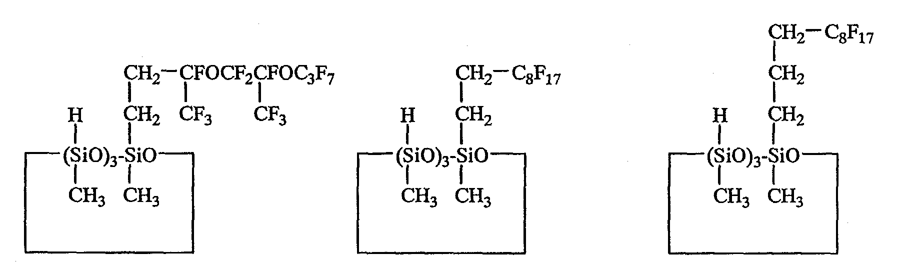

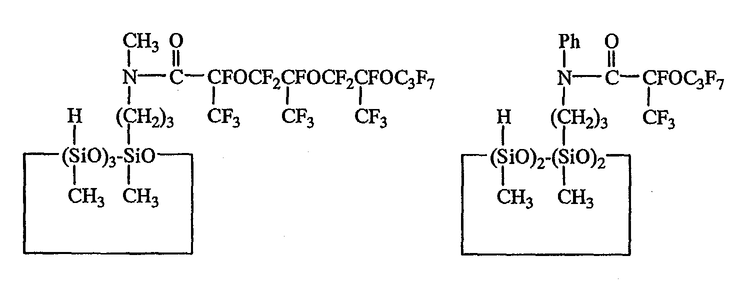

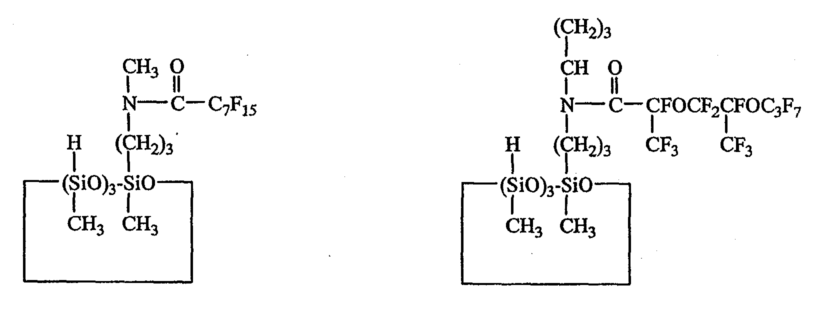

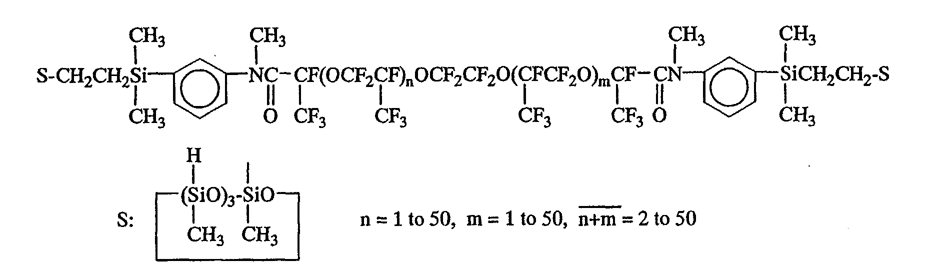

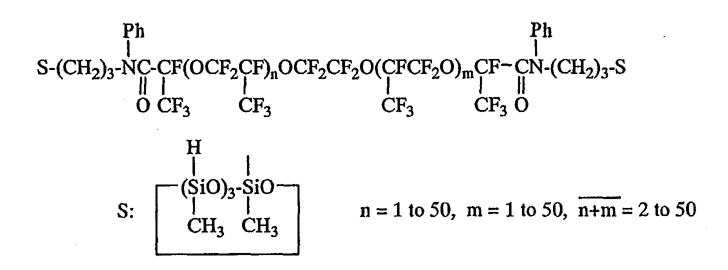

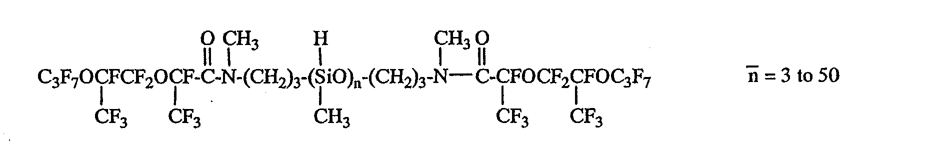

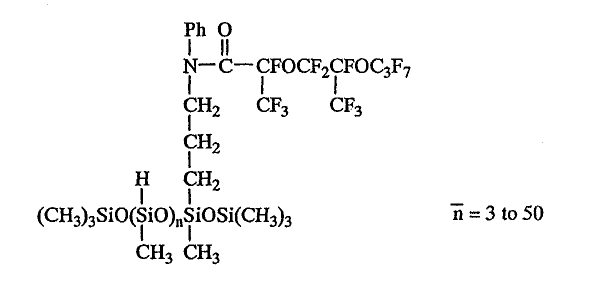

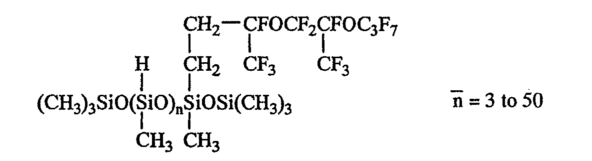

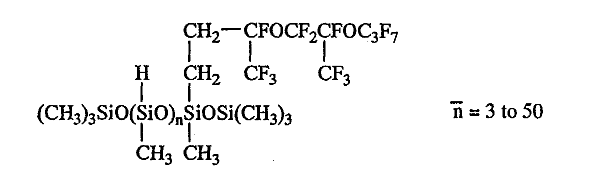

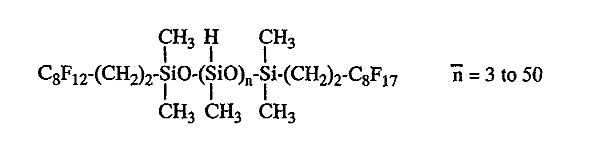

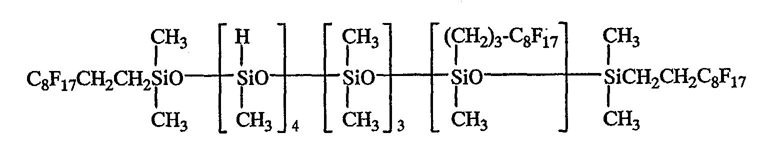

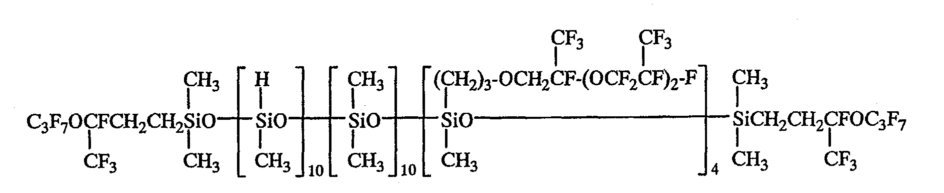

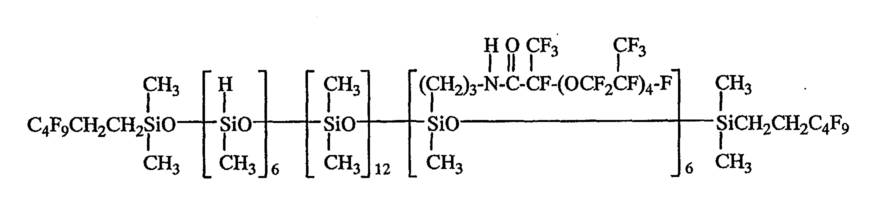

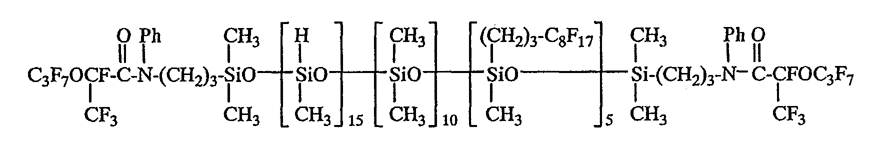

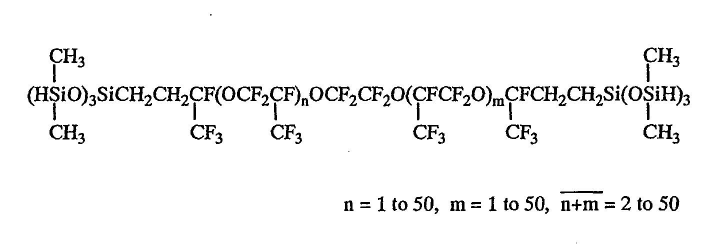

Component (B) is included in an effective amount to cure component (A), preferably in such amounts that 0.2 to 2 moles, more preferably 0.5 to 1.3 moles of hydrosilyl groups (i.e., Si-H groups) are available from component (B) per mole of total alkenyl groups in component (A). Amounts of component (B) to provide less Si-H groups may fail to drive crosslinking to a sufficient degree to form a cured product. Amounts of component (B) to provide too much Si-H groups may invite a risk of foaming upon curing.

### Component C

Component (C) is a platinum group metal catalyst for promoting addition reaction between alkenyl groups in component (A) and hydrosilyl groups in component (B). Platinum compounds are often employed as the catalyst since they are relatively easily available. The platinum compounds include, for example, chloroplatinic acid, complexes of chloroplatinic acid with olefins (such as ethylene), alcohols, vinylsiloxanes or the like, and metallic platinum on silica, alumina or carbon, though not limited thereto. Known examples of the platinum group compounds other than the platinum compound are rhodium, ruthenium, iridium and palladium compounds, for example, RhCl(PPh₃)₃, RhCl(CO)(PPh₃)₂, Ru₃(CO)₁₂, IrCl(CO)(PPh₃)₂, and Pd(PPh₃)₄ wherein Ph is phenyl.

The catalyst is used in a catalytic amount. The preferred amount of the catalyst is about 0.1 to 100 parts by weight of platinum group metal per million parts by weight of components (A) and (B) combined.

### Component D

In addition to components (A) to (C), the curable composition may further include (D) a chain-like polyfluoromonoalkenyl compound having an alkenyl group at one end of its molecular chain and comprising a backbone represented by the following formula.

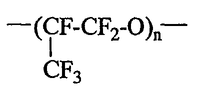

The preferred chain-like polyfluoromonoalkenyl compounds are of the general formula (2):

Rf²- (X')ₐ-CH=CH₂ (2)

wherein X' and "a" are as defined above, Rf² is a group of the general formula (iii):

F-[CF(CF₃)CF₂O]_{w}-CₜF₂ₜ- (iii)

wherein t is as defined above, and w is an integer of at least 1 which is smaller than the sum of p+q (average) plus r and smaller than the sum of u plus v associated with Rf¹ group in component (A).

The definition of w in Rf² group relative to Rf¹ group in component (A) is essential for the inventive composition to form a low-bleed cured product.

Illustrative, non-limiting examples of the polyfluoromonoalkenyl compound having formula (2) are given below. 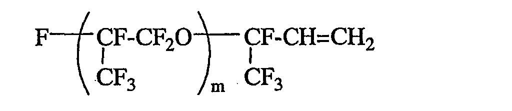 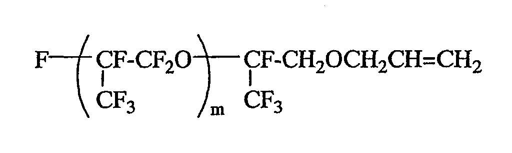 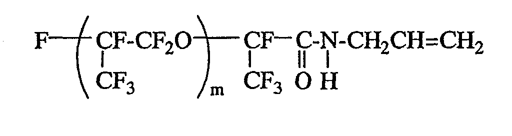 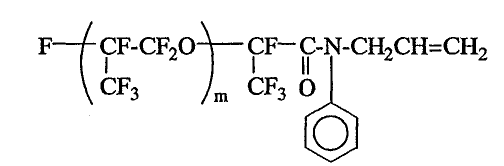 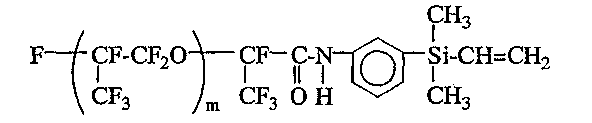 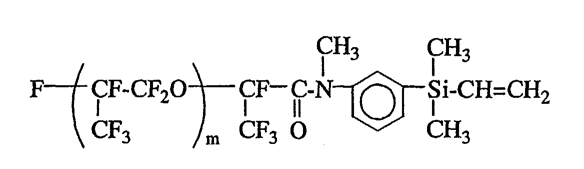 Herein m is an integer of 1 to 200 that satisfies the above-described requirement.

The usual amount of polyfluoromonoalkenyl compound (D) compounded is 40 to 160 parts by weight, preferably 50 to 150 parts by weight per 100 parts by weight of the polyfluorodialkenyl compound (A). Like the polyfluorodialkenyl compound (A), the polyfluoromonoalkenyl compound (D) should preferably have a viscosity at 23°C in the range of 5 to 100,000 mPa·s.

### Component E

In the curable composition of the invention, (E) an organosilicon compound having at least one of trialkoxysilyl and epoxy groups in a molecule may be compounded. When the composition containing component (E) is potted to a semiconductor chip or substrate, the cured composition can be more effectively bonded thereto, achieving further improved reliability.

Examples of the organosilicon compound having at least one of trialkoxysilyl and epoxy groups in a molecule include those of the following structural formulae. These compounds may be used alone or in admixture of any.

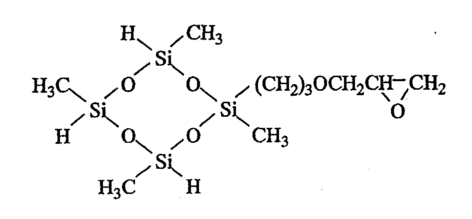

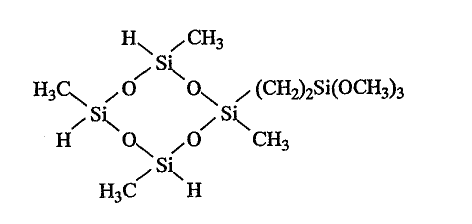

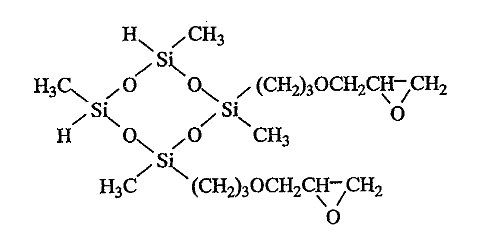

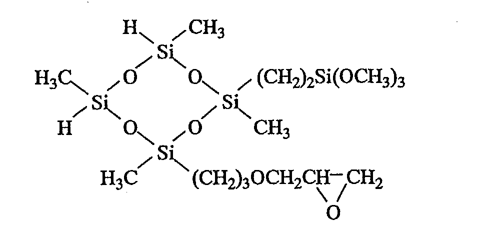

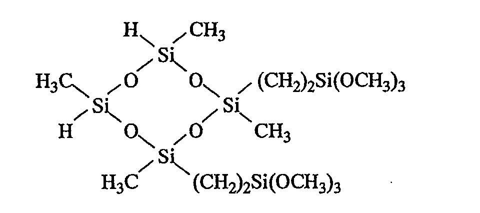

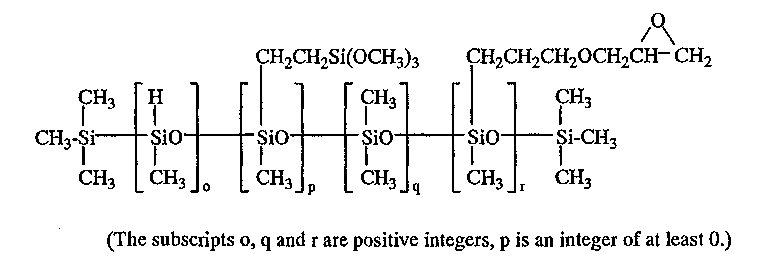

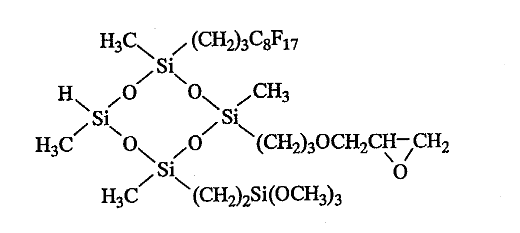

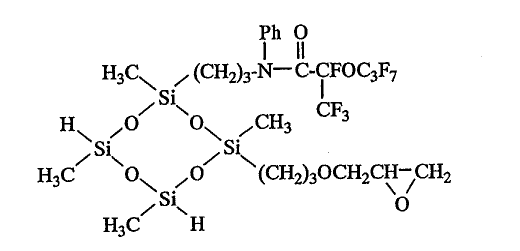

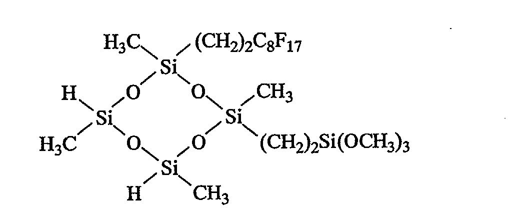

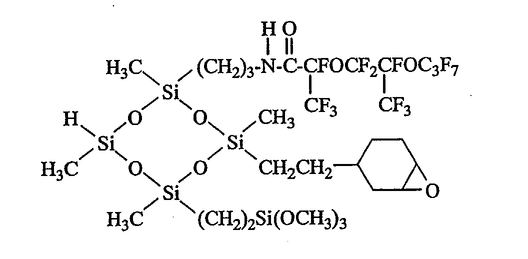

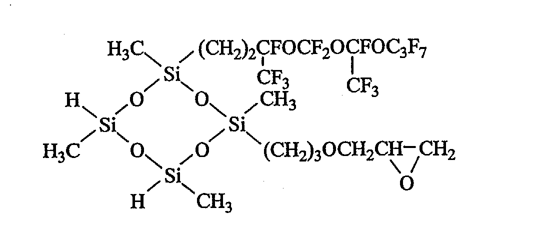

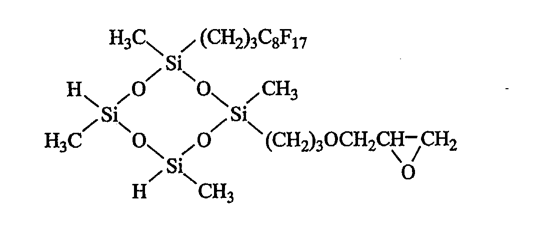

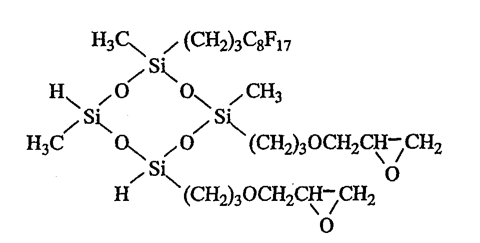

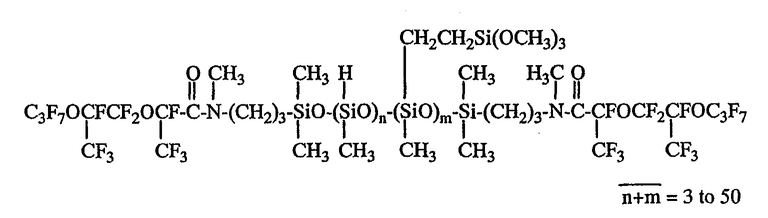

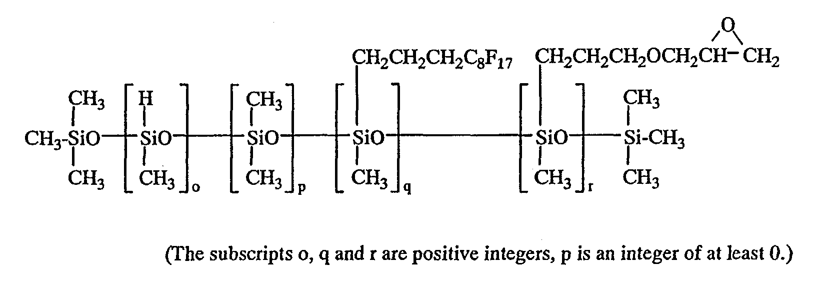

The usual amount of component (E) compounded is 0.1 to 3.0 parts by weight, preferably 0.2 to 2.5 parts by weight per 100 parts by weight of component (A). Less than 0.1 pbw of component (E) may fail to provide a tighter bond whereas more than 3.0 pbw may adversely affect the flow of the composition to prevent the composition from being extruded from a dispenser unit, and reduce the physical strength of the cured composition.

### Other components

Beside the above-mentioned components (A) to (E), various ingredients may be added to the inventive composition. Plasticizers such as non-functional perfluoropolyether may be compounded for controlling hardness and glass transition temperature. Regulators suitable for the hydrosilylation catalyst include acetylene alcohols such as 1-ethynyl-1-hydroxycyclohexane, 3-methyl-1-butyn-3-ol, 3,5-dimethyl-1-hexyn-3-ol, 3-methyl-1-penten-3-ol, and phenylbutynol, 3-methyl-3-penten-1-yne, 3,5-dimethyl-3-hexen-1-yne, polymethylvinylsiloxane cyclic compounds, and organophosphorus compounds. Such regulators, when added, are effective for maintaining appropriate curing reaction and shelf stability. Inorganic fillers include fumed silica, ground silica, iron oxide, zinc oxide, titanium oxide, calcium carbonate, magnesium carbonate, zinc carbonate, and carbon black. Such fillers, when added, are effective for adjusting the hardness and mechanical strength of the cured composition. It is also acceptable to add hollow inorganic fillers or spherical rubbery fillers. These ingredients may be used in any desired amounts as long as they do not compromise the properties of the resulting composition and the physical properties of the cured product.

The semiconductor package and its protective material typically operates at a high frequency, and is exposed to varying temperatures and/or humidity, and perhaps to mechanical shocks. The cured composition is preferably a rubber material having a hardness of up to 80 according to JIS K6253 or a gel material having a penetration of at least 1 according to the consistency test of JIS K2220 (using 1/4 cone). Due to very low hardness, this material serves to mitigate the temperature history at low temperatures or mechanical impact as by vibration, and overcome such problems as a lowering of insulation and breakage of bonding wires, offering a semiconductor package having drastically improved operational reliability.

### EXAMPLE

Examples of the invention are given below by way of illustration and not by way of limitation. Parts are by weight.

### Preparation Example 1

Aerosil R-976 (Nippon Aerosil Co., Ltd.), 1.5 parts, was incorporated in 100 parts of a polymer of formula A-1 (viscosity 2,100 mPa·s). To the polymer were further added 0.3 part of a 50% toluene solution of ethynyl cyclohexanol, 0.2 part of a toluene solution of chloroplatinic acid/vinylsiloxane complex (platinum atom concentration 0.5 wt%), 6.2 parts of a compound of formula B-1, 1.5 parts of a compound of formula B-2, and 1.5 parts of a compound of formula E-1. The components were intimately mixed to form a rubber composition 1.

The rubber composition 1 was press molded at 150°C for 10 minutes and post-cured at 150°C for 50 minutes, obtaining a rubber material 1. The cured material was measured for physical properties according to JIS K6249. The results are shown in Table 1.

### Preparation Example 2

A rubber composition 2 was prepared as in Preparation Example 1 by mixing the same compounds in the proportion shown in Table 1, except that a polymer of formula A-2 (viscosity 5,600 mPa·s) was used instead of the polymer of formula A-1. As in Preparation Example 1, the rubber composition 2 was press molded and post-cured, obtaining a rubber material 2. The cured material was similarly measured for physical properties. The results are shown in Table 1.

### Preparation Example 3

Aerosil R-972 (Nippon Aerosil Co., Ltd.), 4.0 parts, was incorporated in 100 parts of a polymer of formula A-2 (viscosity 5,600 mPa·s). To the polymer were further added 0.3 part of a 50% toluene solution of ethynyl cyclohexanol, 0.2 part of a toluene solution of chloroplatinic acid/vinylsiloxane complex (platinum atom concentration 0.5 wt%), 1.1 parts of a compound of formula B-2, 1.7 parts of a compound of formula B-3, and 2.5 parts of a compound of formula E-2. The components were intimately mixed to form a rubber composition 3. As in Preparation Example 1, the rubber composition 3 was press molded and post-cured, obtaining a rubber material 3. The cured material was similarly measured for physical properties. The results are shown in Table 1.

### Preparation Example 4

To 65 parts of a polymer of formula A-2 (viscosity 5,600 mPa·s) and 35 parts of a polymer of formula D-1 (viscosity 650 mPa·s) were added 0.15 part of a 50% toluene solution of ethynyl cyclohexanol, 0.015 part of an ethanol solution of chloroplatinic acid/vinylsiloxane complex (platinum atom concentration 3.0 wt%), and 20 parts of a compound of formula B-5. The components were intimately mixed to form a gel composition 1.

The gel composition 1 was then heated at 150°C for one hour to form a gel material 1. The penetration of the (cured) gel material was measured by the consistency test of JIS K2220 (using 1/4 cone). The results are shown in Table 2.

### Preparation Example 5

A gel composition 2 was prepared as in Preparation Example 4 by mixing the same compounds in the proportion shown in Table 2, except that a polymer of formula A-1 (viscosity 2,100 mPa·s) was used instead of the polymer of formula A-2, and a compound of formula B-4 was used instead of the compound of formula B-5. As in Preparation Example 4, the gel composition 2 was then heated to form a gel material 2. The penetration of the (cured) gel material was similarly measured. The results are shown in Table 2.

### Preparation Example 6

To 57 parts of a polymer of formula A-2 (viscosity 5,600 mPa·s), 43 parts of a polymer of formula D-1 (viscosity 650 mPa·s) and 3 parts of Cabosil TS720 (Cabot Corp.) were added 0.15 part of a 50% toluene solution of ethynyl cyclohexanol, 0.015 part of an ethanol solution of chloroplatinic acid/vinylsiloxane complex (platinum atom concentration 3.0 wt%), and 23 parts of a compound of formula B-5. The components were intimately mixed to form a gel composition 3. As in Preparation Example 4, the gel composition 3 was then heated to form a gel material 3. The penetration of the (cured) gel material was similarly measured. The results are shown in Table 2.

### Component A:

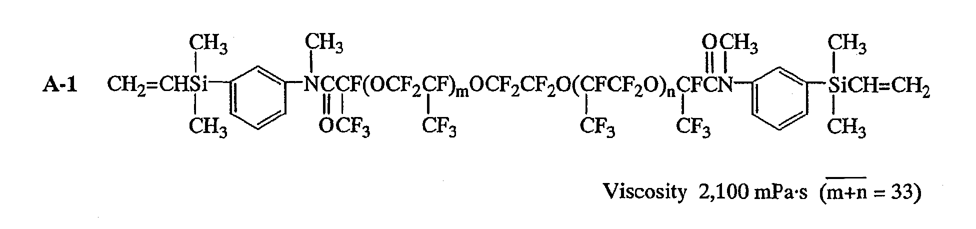

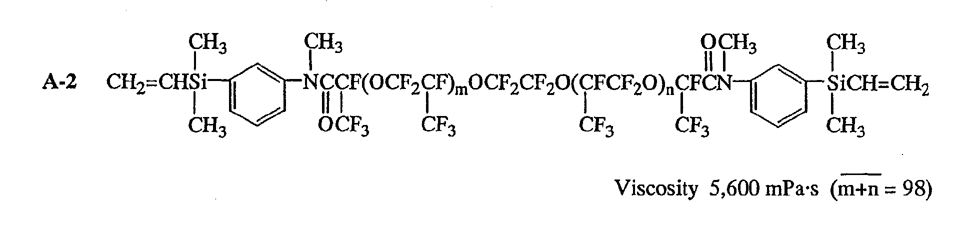

### Component B:

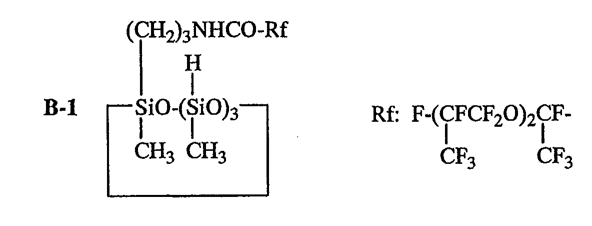

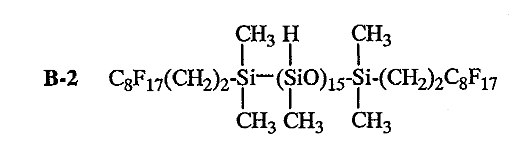

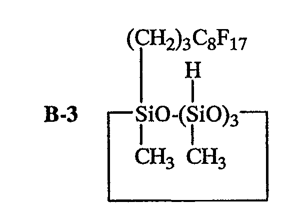

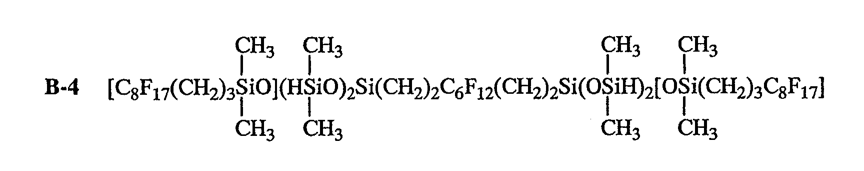

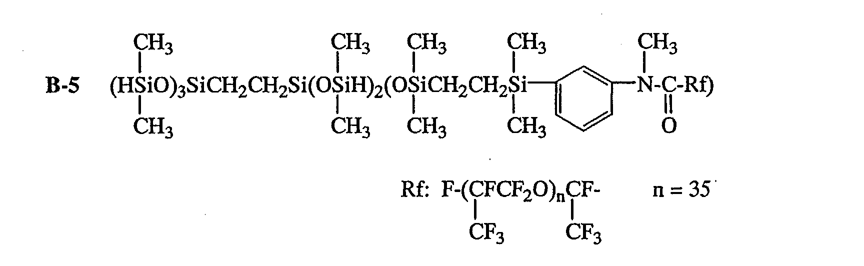

### Component D:

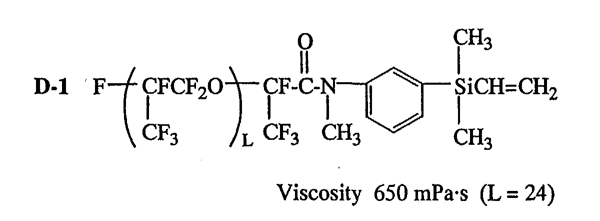

### Component E:

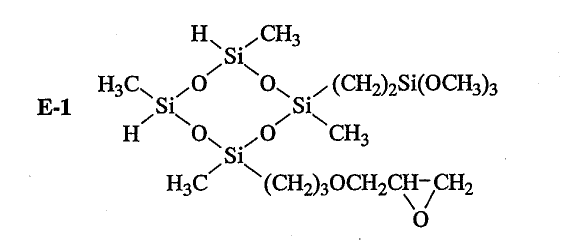

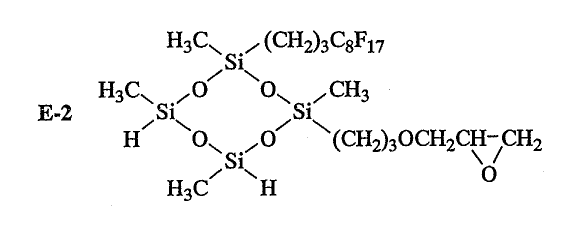

**Table 1**

| Components (pbw) | | Preparation Example 1 | Preparation Example 2 | Preparation Example 3 |
|---|---|---|---|---|
| | | Rubber composition 1 | Rubber composition 2 | Rubber composition 3 |
| Component A | A-1 | 100 | | |
| | A-2 | | 100 | 100 |
| Component B | B-1 | 6.2 | 1.9 | |
| | B-2 | 1.5 | 1.1 | 1.1 |
| | B-3 | | | 1.7 |
| Component E | E-1 | 1.5 | 1.0 | |
| | E-2 | | | 2.5 |
| Filler | Aerosil | 1.5 | 1.5 | 4.0 |
| Rubber physical properties | | | | |
| Hardness (Durometer A) | | 25 | 28 | 18 |
| Tensile strength (MPa) | | 0.5 | 0.8 | 0.8 |
| Elongation (%) | | 160 | 190 | 250 |

**Table 2**

| Components (pbw) | | Preparation Example 4 | Preparation Example 5 | Preparation Example 6 |
|---|---|---|---|---|
| | | Gel composition 1 | Gel composition 2 | Gel composition 3 |
| Component A | A-1 | | 42 | |
| | A-2 | 65 | | 57 |
| Component B | B-4 | | 14 | |
| | B-5 | 20 | | 23 |
| Component D | D-1 | 35 | 58 | 43 |
| Filler | Cabosil TS720 | | | 3 |
| Gel physical properties | | | | |
| Hardness (penetration) | | 20 | 68 | 42 |

### Examples 1-6

In accordance with the structure shown in FIG. 1, the rubber composition or gel composition of Preparation Examples 1 to 6 as a protective material was applied to cover a semiconductor device (silicon chip) 2 and bonding wires 5, completing a semiconductor IC package. The properties of the semiconductor package were determined at the initial and after holding under the following conditions.
Hot holding conditions: 120°/500 hr
Hot humid holding conditions: 85°/85% RH/500 hr

Relative permittivity was measured according to JIS K6249. High-frequency response was measured by a pulse wave meter. The results are shown in Table 3. FIG. 4 shows the relative permittivity versus frequency of Example 1.

### Comparative Examples 1-2

Semiconductor IC packages were fabricated as in Examples 1-6 aside from using a silicone resin (trade name: KJR-9014 by Shin-Etsu Chemical Co., Ltd.) or an epoxy resin (trade name: CV5144AH by Matsushita Electric Co., Ltd.) instead of the rubber or gel composition. Their physical properties were measured.

**Table 3**

| | | Example | | | | | | Comparative Example | |
|---|---|---|---|---|---|---|---|---|---|
| | | 1 | 2 | 3 | 4 | 5 | 6 | 1 | 2 |
| | | Rubber material 1 | Rubber material 2 | Rubber material 3 | Gel material 1 | Gel material 2 | Gel material 3 | Silicone resin | Epoxy resin |
| Relative permittivity (10 MHz/23°C) | | 2.2 | 2.2 | 2.2 | 2.2 | 2.2 | 2.2 | 2.8 | 3.5 |
| High-frequency response (10 MHz) | Initial | ○ | ○ | ○ | ○ | ○ | ○ | ○ | × |
| | After hot holding | ○ | ○ | ○ | ○ | ○ | ○ | ○ | ○ |
| | After hot humid holding | ○ | ○ | ○ | ○ | ○ | ○ | × | × |
| ○: acceptable, ×: unacceptable | | | | | | | | | |

## Claims

1. A semiconductor package comprising a semiconductor chip, leads for conveying electrical signals, and bonding wires for electrically connecting said chip and said leads, at least portions of said chip, said bonding wires and said leads being covered and protected with an electrically insulating fluorochemical material, wherein
said fluorochemical material is a cured product of a curable composition comprising
(A) 100 parts by weight of a chain-like polyfluorodialkenyl compound having alkenyl groups at both ends of its molecular chain and comprising a backbone represented by the formula: 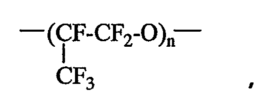
(B) an effective amount of organohydrogenpolysiloxane having at least two silicon atom-bonded hydrogen atoms per molecule, and
(C) a catalytic amount of platinum group metal catalyst.

2. The semiconductor package of claim 1, wherein said fluorochemical material has a relative permittivity of up to 2.5 in a frequency range of at least 1 MHz.

3. The semiconductor package of claim 1 or 2, wherein said curable composition further comprises (D) 40 to 160 parts by weight of a chain-like polyfluoromonoalkenyl compound having an alkenyl group at one end of its molecular chain and comprising a backbone represented by the formula:

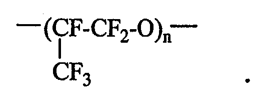

4. The semiconductor package of claim 1 or 2, wherein said curable composition further comprises (E) 0.1 to 3.0 parts by weight of organosilicon compound having at least one of trialkoxysilyl and epoxy groups per molecule.

5. The semiconductor package of any one of claims 1 to 4, wherein component (A) is a branched chain-like polyfluorodialkenyl compound having the general formula (1):
CH₂=CH-(X)ₐ-Rf¹-(X')ₐ-CH=CH₂ (1)
wherein X is a divalent group selected from among -CH₂-, -CH₂O-, -CH₂OCH₂- and -Y-NR¹-CO-, wherein Y is -CH₂- or a divalent group of the formula: 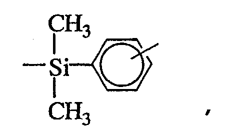 and R¹ is hydrogen or a substituted or unsubstituted monovalent hydrocarbon group,
X' is a divalent group selected from among -CH₂-, -OCH₂-, -CH₂OCH₂- and -CO-NR¹-Y'-, wherein Y' is -CH₂- or a divalent group of the formula: 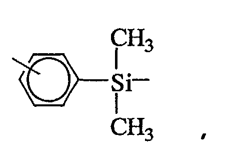 and R¹ is as defined above,
indices "a" are independently 0 or 1,
Rf¹ is a divalent group of the general formula (i):
-CₜF₂ₜ-[OCF₂CF(CF₃)]ₚ-[OCF₂(CF₂)ᵣCF₂O]-[CF(CF₃)CF₂O]_{q}-CₜF₂ₜ- (i)
wherein p and q each are an integer of at least 1, the sum of p and q is 2 to 200 on average, r is an integer of 0 to 6, and t is 2 or 3,
or the general formula (ii):
-CₜF₂ₜ-[OCF(CF₃)CF₂]ᵤ-(OCF₂)ᵥ-OCₜF₂ₜ- (ii)
wherein u is an integer of 1 to 200, v is an integer of 1 to 50, and t is as defined above.

6. The semiconductor package of claim 3 or 5, wherein component (D) is a branched chain-like polyfluoromonoalkenyl compound having the general formula (2):
Rf²-(X')ₐ-CH=CH₂ (2)
wherein X' and "a" are as defined in claim 5, Rf² is a group of the general formula (iii):
F-[CF(CF₃)CF₂O]_{w}-CₜF₂ₜ- (iii)
wherein w is an integer of at least 1 and t is as defined above.

7. Use of a curable composition as defined in any one of claims 1 to 6 for protecting a semiconductor package.
